(19) Europäisches Patentamt
European Patent Office
Office européen des brevets

(11) **EP 0 581 835 B3**

(12) **NEUE EUROPÄISCHE PATENTSCHRIFT**
Nach dem Beschränkungsverfahren (B3-1)

(45) Veröffentlichungstag und Bekanntmachung des Hinweises auf die Entscheidung über den Antrag auf Beschränkung:
**B3-1  03.12.2008  Patentblatt 2008/49**

(45) Hinweis auf die Patenterteilung:
**19.08.1998  Patentblatt 1998/34**

(21) Anmeldenummer: **92909402.7**

(22) Anmeldetag: **25.04.1992**

(51) Int Cl.:
*H03G 1/00* *(2006.01)*     *H03G 7/06* *(2006.01)*

(86) Internationale Anmeldenummer:
**PCT/EP1992/000912**

(87) Internationale Veröffentlichungsnummer:
**WO 1992/020148 (12.11.1992 Gazette 1992/28)**

(54) **SCHALTUNG FÜR EINEN REGELBAREN VERSTÄRKER**

CIRCUIT FOR CONTROLLABLE AMPLIFIER

CIRCUIT POUR AMPLIFICATEUR A REGULATION

(84) Benannte Vertragsstaaten:
**AT BE CH DE DK ES FR GB IT LI NL PT SE**

(30) Priorität: **25.04.1991  DE 4113498**

(43) Veröffentlichungstag der Anmeldung:
**09.02.1994  Patentblatt 1994/06**

(73) Patentinhaber: **Deutsche Thomson OHG**
**30625 Hannover (DE)**

(72) Erfinder:
• **ITRI, Sossio**
**D-38448 Wolfsburg 11 (DE)**
• **RIEGER, Martin**
**D-78628 Rottweil-Neukirch (DE)**

(74) Vertreter: **Rossmanith, Manfred**
**Deutsche Thomson OHG**
**European Patent Operations**
**Karl-Wiechert-Allee 74**
**30625 Hannover (DE)**

(56) Entgegenhaltungen:
**DE-A1- 3 522 416       US-A- 4 429 416**

Bemerkungen:
Verbunden mit 92107119.7/0510704 (europäische Anmeldenummer/Veröffentlichungsnummer) durch Entscheidung vom 10.05.96.

**Beschreibung**

Die Erfindung betrifft eine Schaltung für einen regelbaren Verstärker.

Stand der Technik

Es sind regelbare Verstärker bekannt, die z.B. zur Amplitudenregelung von ZF-Signalen verwendet werden. Ein solcher Verstärker ist beispielsweise in dem integrierten Schaltkreis vom Typ TDA 4443 enthalten. Diese bekannten Verstärker sind aber nicht rauscharm oder haben eine eingeschränkte Linearität oder die Regelcharakteristik ist nicht dB-linear.

Es ist ferner bekannt aus DE-A-35 22 416, daß für den dort beschriebenen regelbaren Verstärker die Verstärkung eines Differenzverstärkers mit Hilfe unterschiedlicher Emitterwiderstände geregelt wird.

Erfindung

Der Erfindung liegt die Aufgabe zugrunde, eine Schaltung für einen regelbaren Verstärker mit erhöhter Linearität und verbessertem Rauschverhalten anzugeben. Diese Aufgabe wird durch die in Anspruch 1 angegebene erfindungsgemäße Schaltung gelöst.

Im Prinzip ist die erfindungsgemäße Schaltung versehen mit einem Differenzverstärker für eine Eingangsspannung, der einen ersten Transistor und einen zweiten Transistor enthält, die durch eine Serienschaltung von mindestens drei Widerständen verbunden sind, wobei zwischen diesen Widerständen jeweils mindestens ein Bauelement abzweigt, welches jeweils mit mindestens einer Stromquelle verbunden ist und wobei der Strom dieser Stromquellen in Abhängigkeit von der Eingangsspannung veränderbar ist.
Vorteilhaft ist dabei insbesondere bei einer dB-linearen Regelung der Strom der Stromquellen zusätzlich von einer Referenzspannung abhängig, wobei die jeweilige Referenzspannung für die in der Mitte der Serienschaltung liegenden Bauelemente am niedrigsten und für die am nächsten zu den Enden der Serienschaltung liegenden Bauelemente am höchsten ist. Vorteilhaft bei einer linearen Regelung ist, daß die Ströme der Stromquellen proportional zueinander sind und von der Mitte zu den Enden der Serienschaltung hin kleiner werden.

Vorteilhafte Weiterbildungen der erfindungsgemäßen Schaltung ergeben sich aus den entsprechenden Unteransprüchen.

In einem Differenzverstärker wird das Gesamt-Gegenkopplungs-Netzwerk aufgeteilt in einzelne Netzwerke, die jeweils mit mindestens einem eigenen Steuerstrom versorgt werden. Um Verzerrungen durch in den Netzwerken enthaltene nichtlineare Bauelemente, z.B. Diodenstrecken, gering zu halten bzw. die Intermodulationsfestigkeit zu erhöhen, werden die einzelnen Steuerströme mit ansteigender Eingangsspannung kleiner. Zur Realisierung einer dB-linearen Regelcharakteristik können die Steuerströme z.B. tanh-förmige (tangens hyperbolicus) oder ähnliche Kennlinien erhalten. Außerdem ist ein solcher Verstärker aufgrund seiner Struktur und seines Funktionsprinzips relativ rauscharm.

Zeichnungen

Anhand der Zeichnungen werden Ausführungsbeispiele der Erfindung beschrieben. Die Zeichnungen zeigen in:

Fig. 1    bekannte Schaltung für einen regelbaren Verstärker;
Fig. 2    erfindungsgemäße Schaltung für einen regelbaren Verstärker;
Fig. 3    Steuerstrom-Kennlinien für den Verstärker nach Fig. 2;
Fig. 4    Steuerstrom-Kennlinien für eine dB-lineare Regelcharakteristik;
Fig. 5    Schaltung zur Erzeugung von Kennlinien nach Fig. 4;
Fig. 6    Verstärker-Block aus mehreren Einzelverstärkern;
Fig. 7    Steuerstrom-Kennlinien für eine lineare Regelcharakteristik;
Fig. 8    eine weitere erfindungsgemäße Schaltung für einen regelbaren Verstärker.

Ausführungsbeispiel

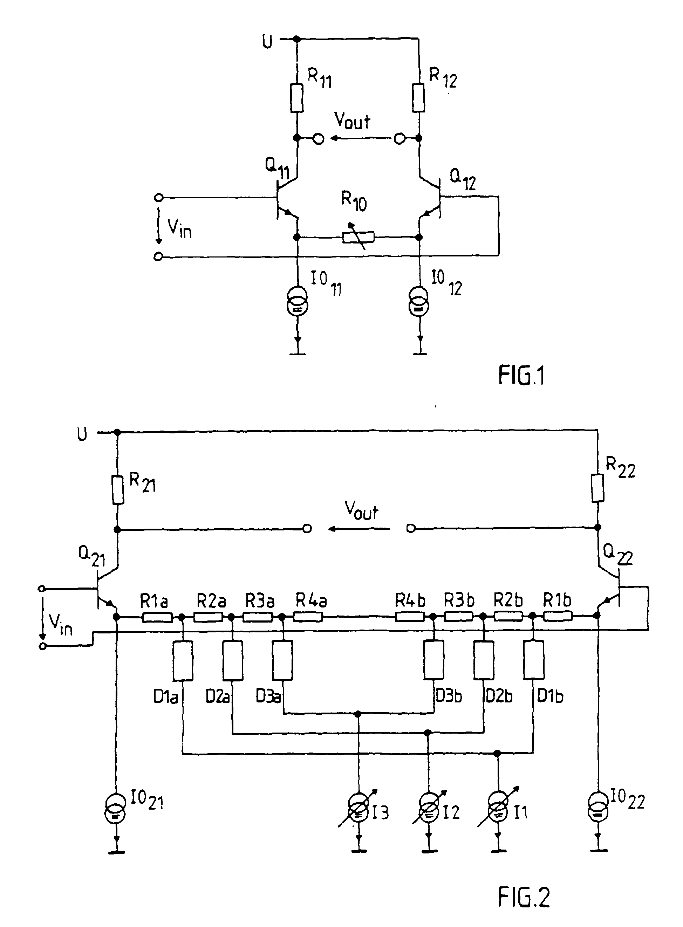

Fig. 1 enthält einen ersten Transistor $Q_{11}$ und einen zweiten Transistor $Q_{12}$, die als Differenzverstärker geschaltet sind. Die Kollektoren dieser Transistoren sind über einen ersten Widerstand $R_{11}$ bzw. zweiten Widerstand $R_{12}$ an die Versorgungsspannung U angeschlossen. Die Emitter dieser Transistoren sind über eine erste Stromquelle $IO_{11}$ bzw. zweite Stromquelle $IO_{12}$ an Masse angeschlossen. Den Basen der beiden Transistoren wird die Eingangs-

spannung $V_{in}$ zugeführt. Zwischen den Kollektoren der beiden Transistoren ist die Ausgangsspannung $V_{out}$ abgreifbar. Zwischen den Emittern der beiden Transistoren ist ein regelbarer Widerstand $R_{10}$ angeschlossen, mit dem die Verstärkung der Schaltung eingestellt werden kann. Für $R_{11} = R_{12} = R$ und $IO_{11} = IO_{12} = IO$ gilt:

$$V_{out} = V_{in} * R/R_{10}$$

Fig. 2 enthält ein Netzwerk aus acht in Reihe geschalteten Widerständen R1a-R4a und R1b-R4b, aus sechs jeweils zwischen diesen Widerständen abgehenden Bauelementen D1a-D3a und D1b-D3b und aus drei einseitig an Masse liegenden und an diese Bauelemente angeschlossenen Stromquellen I1-I3, das den regelbaren widerstand $R_{10}$ aus Fig. 1 ersetzt.

Im Fall einer Bipolar-Schaltung können die sechs Bauelemente Dioden sein, deren Durchlaßrichtung zu den Stromquellen I1-I3 zeigt. Der Wechselstromwiderstand dieser Dioden ist dabei gleich $V_T/I$, wobei $V_T$ die Temperaturspannung und I der durch die Diode fließende Strom ist.

Im Fall einer MOS-Schaltung können die sechs Bauelemente als einstellbare Widerstände ausgebildete FET-Transistoren sein. Besonders lineare Widerstände dieser Art lassen sich durch die Kombination von N-MOS- und P-MOS-Transistoren erreichen.

Die Schaltungsteile $Q_{21}$, $Q_{22}$, $R_{21}$, $R_{22}$, $IO_{21}$ und $IO_{22}$ entsprechen den Schaltungsteilen $Q_{11}$, $Q_{12}$, $R_{11}$, $R_{12}$, $IO_{11}$ und $IO_{12}$ aus Fig. 1.

Die Anzahl der den Widerstand $R_{10}$ ersetzenden Schaltungsteile bzw. die Anzahl der hintereinandergeschalteten Teilerstufen kann entsprechend den Erfordernissen für den Regelumfang unter Berücksichtigung der zur Verfügung stehenden Betriebsspannungshöhe variiert werden.

Wenn beginnend bei einem kleinen Pegel die Eingangsspannung $V_{in}$ ansteigt, wird zunächst der Strom in der Stromquelle I1 zurückgenommen. Dadurch wird das Bauelement (die Diode) D1a bzw. D1b hochohmig, der Einfluß eventueller, durch große Pegel an D1a bzw. D1b bedingter Verzerrungen auf die Gesamtverzerrungen des Verstärkers wird vernachlässigbar und die Verstärkung wird entsprechend verringert. Die Bauelemente R1a und R2a bzw R1b und R2b wirken nun für das Bauelement D2a bzw. D2b wie ein Spannungsteiler mit vergrößertem Teilerverhältnis, sodaß für die Eingangsspannung $V_{in}$ in Bezug auf D2a bzw. D2b größere Pegel zulässig sind. Dieser Vorgang setzt sich für weiter ansteigende Eingangsspannungen für die entsprechenden folgenden Bauelemente fort.

Es kann beispielsweise folgende Dimensionierung vorgenommen werden:

$$R_{21} = R_{22} = 3.9 \ k\Omega$$

$$R1a = R1b = 100 \ \Omega$$

$$R2a = R2b = 1.38 k\Omega$$

$$R3a = R3b = 1.26 k\Omega$$

$$R4a = R4b = 1.26 k\Omega$$

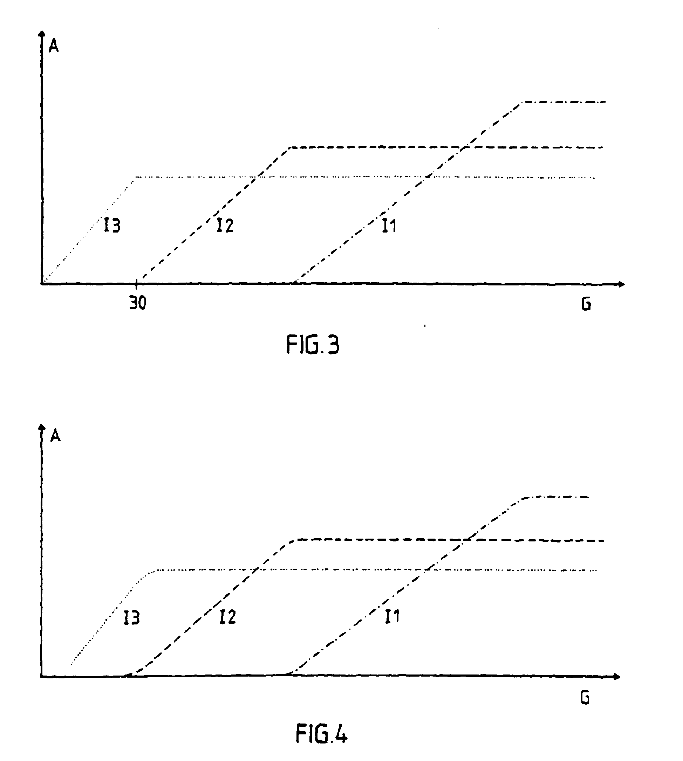

In Fig. 3 ist der Amplitudenverlauf A der Steuerströme der Stromquellen I1, I2 und I3 über der Verstärkung G aufgetragen. Bei großer Verstärkung (d.h. kleiner Eingangsspannung $V_{in}$) haben alle Steuerströme ihren Maximalwert. Bei steigender Eingangsspannung (d.h. sinkender Verstärkung) wird zunächst Steuerstrom der Stromquelle I1 zurückgenommen. Spätestens wenn dieser Steuerstrom zu Null geworden ist, fällt der Steuerstrom der Stromquelle 12. Spätestens wenn dieser Steuerstrom zu Null geworden ist, fällt der Steuerstrom der Stromquelle 13. Wenn dieser Steuerstrom zu Null geworden ist, liegt die Minimal-Verstärkung vor. Entsprechendes gilt für eventuelle weitere Steuerströme.

Auf diese Weise kann die Ausgangsspannung $V_{out}$ innerhalb des Verstärker-Regelbereichs unabhängig vom Pegel der Eingangsspannung $V_{in}$ konstant gehalten werden, wobei die Linearität innerhalb dieses Regelbereichs gegenüber dem bekannten Regelverstärker deutlich erhöht ist.

Durch den Verlauf der Steuerströme der Stromquellen I1-I3 kann die Regelcharakteristik des Verstärkers in Fig. 2 entsprechend beeinflußt werden. Durch einen höheren Steuerstrom kann auch eine höhere Maximalverstärkung erreicht werden. Die Anzahl der Steuerströme kann den jeweiligen Erfordernissen an den Gesamt-Regelbereich und an die Linearität, angepaßt werden, jedoch ist bei steigender Anzahl von Steuerströmen oder bei steigendem Betrag der Steuerströme auch eine entsprechend erhöhte Betriebsspannung U erforderlich. Der Verstärkungs-Faktor 30 an der Stelle, wo der Steuerstrom der Stromquelle I2 zu Null geworden ist und der Steuerstrom, der Stromquelle I3 gerade mit der Absenkung beginnt sowie die entsprechenden Verstärkungfaktoren für die anderen Steuerströme, lassen sich durch Referenzspannungen festlegen, die der jeweiligen Stromquelle I1, I2, und I3 zugeführt werden.

Ein ZF-Verstärker hat z.B. einen Regelumfang von 60dB. Wenn mit einer Kontrollspannung $V_{AGC}$ beispielsweise eine Verstärkung von 6dB eingestellt werden soll, ergibt sich bei einer linearen Regelungscharakteristik diese Kontrollspannung zu nur

$$V_{AGC6dB} = (2/1000)*V_{AGCmax} \quad (6dB = \text{Faktor } 2, 60dB = \text{Faktor } 1000).$$

Bei einer dB-linearen Regelungscharakteristik ergäbe sich dagegen eine Kontrollspannung von

$$V_{AGC6dB} = (6/60)*V_{AGCmax}.$$

Darum hat eine dB-lineare Regelungscharakteristik Vorteile bezüglich der Einfachheit der Regelung, der Regelgeschwindigkeit und der Regelstabilität (Regelsprünge).

Mit der erfindungsgemäßen Schaltung läßt sich vorteilhaft leicht eine solche dB-lineare Regelungscharakteristik erreichen. In Fig. 4 ist ein entsprechend verbesserter Amplitudenverlauf A der Steuerströme der Stromquellen I1, I2 und I3 über der Verstärkung G aufgetragen. Die einzelnen Kennlinien haben einen tanh-ähnlichen Verlauf. Die Aussagen zu Fig. 3 gelten hier entsprechend.

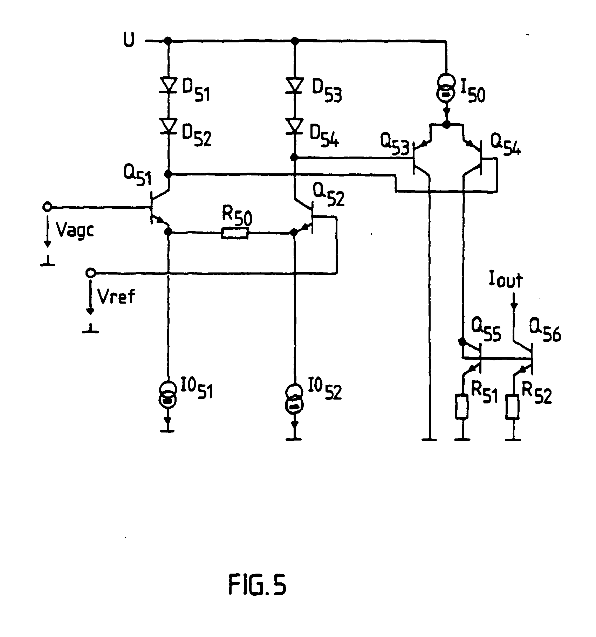

Mit einer Stromquellen-Schaltung nach Fig. 5 läßt sich eine Stromquelle I1, I2, oder I3 realisieren, die eine der Fig. 4 entsprechende Kennlinie hat.

Den drei Stromquellen-Schaltungen wird die gemeinsame Kontrollspannung $V_{AGC}$ und jeweils eine individuelle Referenzspannung $V_{ref}$ zugeführt. Die Kontrollspannung $V_{AGC}$ und die Referenzspannung $V_{ref}$ gelangen zu zwei Differenzverstärker-Transistoren $Q_{51}$ bzw. $Q_{52}$, deren Emitter mit einem Widerstand $R_{50}$ untereinander und jeweils über eine Stromquelle $IO_{51}$ bzw. $IO_{52}$ mit Masse verbunden sind. Der Kollektor von $Q_{51}$ ist über zwei Dioden $D_{51}$ und $D_{52}$ und der Kollektor von $Q_{52}$ ist über zwei Dioden $D_{53}$ und $D_{54}$ mit der Betriebsspannung U verbunden. Die Spannungsdifferenz zwischen den beiden Kollektoren wird auf die Basisanschlüsse eines weiteren Differenzverstärker-Transistorenpaars $Q_{53}$ und $Q_{54}$ gegeben und somit in Abhängigkeit vom Differenzverstärker mit den Transistoren $Q_{51}$ und $Q_{52}$ gesteuert. Die Emitter von $Q_{53}$ und $Q_{54}$ sind über eine dritte Stromquelle $I_{50}$ mit der Betriebsspannung verbunden. Der Kollektor von $Q_{53}$ liegt an Masse. Der Kollektor von $Q_{54}$ ist mit Basis und Kollektor eines fünften Transistors $Q_{55}$ verbunden, dessen Emitter über einen zweiten Widerstand $R_{51}$ an Masse liegt und dessen Basis an die Basis eines sechsten Transistors $Q_{56}$ angeschlossen ist. Der Emitter des sechsten Transistors liegt über einen dritten Widerstand $R_{52}$ an Masse. Am Kollektor ist der jeweilige Steuerstrom der Stromquelle I1, I2 oder I3 abgreifbar.

Es sei $v = (V_{AGC} - V_{ref})$, $I_0$ der von den Stromquellen $IO_{51}$ und $IO_{52}$ und $IO_{50}$ der von der Stromquelle $I_{50}$ eingeprägte Strom. Dann ergibt sich der jeweilige Ausgangsstrom $I_{out}$ zu

$$I_n = C*IO_{50}*[1/(1+((IO+v/R_{50})/(IO-v/R_{50}))^k)],$$

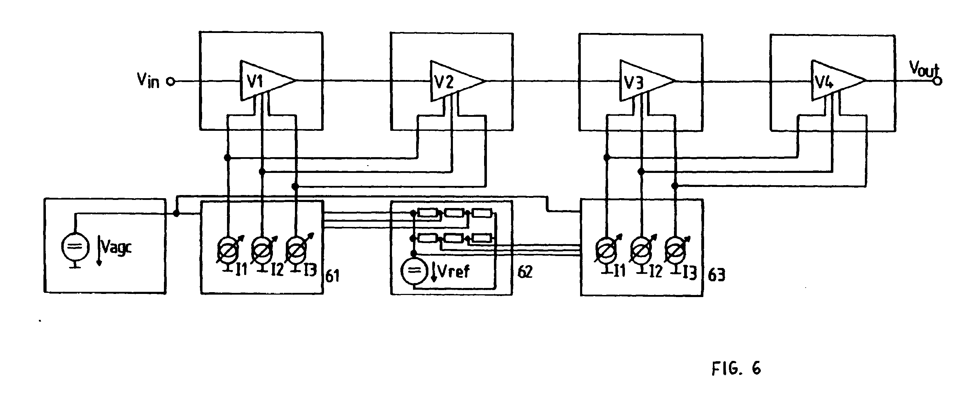

wobei n der Index der jeweiligen Kennlinie (n = 1,2,3), k die Anzahl der hintereinandergeschalteten Dioden und C eine Konstante ist, z.B. C = 3. In der Stromquellen-Schaltung nach Fig. 5 ist daher k = 2. Die jeweilige Steilheit der Steuerstrom-Kennlinien ist durch $R_{50}$ und das Verhältnis $IO_{50}/I_0$ und der jeweilige Maximalwert des Steuerstroms durch $IO_{50}$ gegeben. Es kann beispielsweise für den in Fig. 6 beschriebenen ersten Stromquellenblock 61 folgende Dimensionierung vorgenommen werden:

$$U = 7.7V$$

Stromquelle I1:

$$R_{50} = 8.0k\Omega$$

$$R_{51} = R_{52} = 2.7k\Omega$$

$$I_0 = 167\mu A$$

$$\text{Strom von } I_{50} = 103\mu A$$

$$V_{ref} = 3.624V$$

Stromquelle I2:

$$R_{50} = 10.0k\Omega$$

$$R_{51} = R_{52} = 2.25k\Omega$$

$$I_0 = 50.6\mu A$$

$$\text{Strom von } I_{50} = 1.3\mu A$$

$$V_{ref} = 2.676V$$

Stromquelle I3:

$$R_{50} = 4.0k\Omega$$

$$R_{51} = R_{52} = 1.5k\Omega$$

$$I_0 = 50.5\mu A$$

$$\text{Strom von } I_{50} = 1.3\mu A$$

$$V_{ref} = 2.179V$$

Für den in Fig. 6 beschriebenen zweiten Stromquellenblock 63 ergibt sich folgende abweichende Dimensionierung: Stromquelle I1:

$$I_0 = 169 \mu A$$

$$V_{ref} = 5.67V$$

Stromquelle I2:

$$I_0 = 51.4 \mu A$$

$$V_{ref} = 4.766V$$

Stromquelle I3:

$$I_0 = 51.3 \mu A$$

$$V_{ref} = 4.326V$$

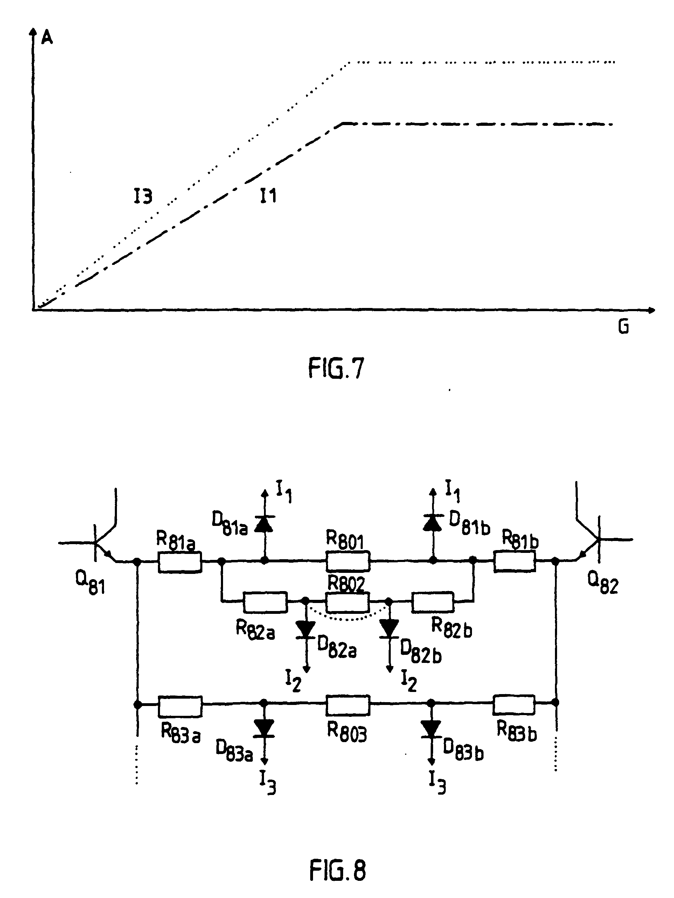

Der ZF-Verstärker-Block in Fig. 6 enthält vier Einzelverstärker V1-V4, die jeweils einem regelbaren Verstärker nach Fig. 2 entsprechen. Die von diesen Regelverstärkern benötigten Steuerströme liefern sechs Stromquellen-Schaltungen gemäß Fig. 5, von denen die ersten drei zu einem ersten Stromquellen-Block 61 und die anderen drei zu einem zweiten Stromquellen-Block 63 zusammengefaßt sind. Der erste Stromquellen-Block 61 steuert den ersten V1 und zweiten V2 Einzelverstärker und der zweite Stromquellen-Block 63 den dritten V3 und vierten V4 Einzelverstärker. Die Anzahl der Stromquellen-Blöcke kann je nach verlangter Regelqualität zwischen eins und vier liegen.
Ein Stromquellen-Block entspricht jeweils drei Stromquellen-Schaltungen nach Fig. 5. Die Stromquellen-Blöcke erhalten die gemeinsame Kontrollspannung $V_{AGC}$, aber individuelle Referenzspannungen aus dem Referenzspannungsblock 62.
Vorteilhaft können die hintereinandergeschalteten Regelverstärker den wesentlichen Anteil eines integrierten ZF-Verstärker-Schaltkreises bilden.
Bei einer Ansteuerung mit nur zwei Steuerströmen entsprechend Fig. 7 kann man eine lineare Regelcharakteristik erhalten. Dazu kann in Fig. 2 beispielsweise folgende Dimensionierung vorgenommen werden:

$$R_{21} = R_{22} = 3.0 \text{ k}\Omega$$

$$R1a = R1b = 100 \ \Omega$$

$$R3a = R3b = 2.486 k\Omega$$

$$R4a = R4b = 158 \ \Omega$$

R2a, R2b und I2 entfallen.
Anstelle des Netzwerks aus den acht in Reihe geschalteten Widerständen R1a-R4a und Rlb-R4b, aus sechs jeweils zwischen diesen Widerständen abgehenden Bauelementen D1a-D3a und D1b-D3b und aus drei einseitig an Masse liegenden und an diese Bauelemente angeschlossenen Stromquellen I1-I3 in Fig. 2 kann auch das in Fig. 8 dargestellte Netzwerk verwendet werden.

Es sind jeweils in Serie zwischen den Emittern der den Transistoren $Q_{21}$ und $Q_{22}$ entsprechenden Transistoren $Q_{81}$ und $Q_{82}$ angeordnet:

- die Widerstände $R_{81a}$, $R_{801}$, $R_{81b}$ mit den zwischen ihnen abzweigenden Dioden $D_{81a}$ und $D_{81b}$, die an Stromquellen I1 angeschlossen sind;
- die Widerstände $R_{83a}$, $R_{803}$, $R_{83b}$ mit den zwischen ihnen abzweigenden Dioden $D_{83a}$ und $D_{83b}$, die an Stromquellen I3 angeschlossen sind;
- die Widerstände $R_{82a}$, $R_{802}$, $R_{82b}$ mit den zwischen ihnen abzweigenden Dioden $D_{82a}$ und $D_{82b}$, die an Stromquellen I2 angeschlossen sind, wobei die Widerstände $R_{82a}$ und $R_{82b}$ statt an die Emitter der beiden Transistoren an die Widerstände $R_{81a}$-$R_{801}$ bzw. $R_{81b}$-$R_{801}$ angeschlossen sind.

Parallel zu $R_{802}$ können weitere entsprechende Bauelemente und Stromquellen angeschlossen sein.

**Patentansprüche**

1. Schaltung für einen regelbaren Verstärker, versehen mit einem Differenzverstärker für eine Eingangsspannung ($V_{in}$), der einen ersten Transistor ($Q_{21}$) und einen zweiten Transistor ($Q_{22}$) enthält, deren Emitter jeweils mit einer Stromquelle verbunden sind, wobei die Emitter durch Widerstände miteinander verbunden sind, **dadurch gekennzeichnet, dass** die Emitter durch eine Serienschaltung von mindestens drei Widerständen (R1a-R4a, R1b-R4b; $R_{81a}$, $R_{801}$, $R_{81b}$) verbunden sind, wobei zwischen diesen Widerständen jeweils ein in seinem Widerstand steuerbares Bauelement (D1a-D3a, D1b-D3b; D81a-D81b) abzweigt, welches jeweils mit einer Stromquelle (I1, I2, I3) verbunden ist und wobei der Strom dieser Stromquellen in Abhängigkeit von der Eingangsspannung ($V_{in}$) veränderbar ist und wobei, falls der mittlere ($R_{801}$) der Widerstände aus der Serienschaltung in zwei einzelne Widerstände (R4a, R4b) aufgeteilt ist, von dem Verbindungspunkt zwischen diesen beiden Widerständen kein in seinem Widerstand steuerbares Bauelement abzweigt.

2. Schaltung nach Anspruch 1, **dadurch gekennzeichnet, dass** der Strom der Stromquelle (I1, I2, I3) zusätzlich von einer Referenzspannung ($V_{ref}$) abhängig ist, wobei die jeweilige Referenzspannung für die in der Mitte der Serienschaltung liegenden, in ihrem Widerstand steuerbaren Bauelemente (D3a, D3b) am niedrigsten und für die am nächsten zu den Enden der Serienschaltung liegenden, in ihrem Widerstand steuerbaren Bauelemente (D1a, D1b) am höchsten ist.

3. Schaltung nach Anspruch 1 oder 2, **dadurch gekennzeichnet, dass** die in ihrem Widerstand steuerbaren Bauelemente (D1a-D3a, D1b-D3b) Dioden und/oder als stromsteuerbare Widerstände ausgebildete FET-Transistoren sind, wobei insbesondere N-MOS- und P-MOS-Transistoren kombiniert werden.

4. Schaltung nach einem oder mehreren der Ansprüche 1 bis 3, **dadurch gekennzeichnet, dass** die Kennlinien (Fig. 3) der Ströme der Stromquellen (I1, I2, I3) in der Form Stromamplitude in Abhängigkeit von Verstärkung des Regelverstärkers jeweils aus einem ansteigenden und aus einem flachen Anteil bestehen, wobei jeweils spätestens am Ende des ansteigenden Teils einer Kennlinie der ansteigende Teil der nächsten Kennlinie beginnt und wobei die jeweilige Referenzspannung ($V_{ref}$) Anfang und/oder Ende des ansteigenden Teils der Kennlinie festlegt.

5. Schaltung nach einem oder mehreren der Ansprüche 1 bis 4, **dadurch gekennzeichnet, dass** die Kennlinien (Fig. 4) der Ströme der Stromquellen (I1, I2, I3) im Wesentlichen jeweils eine tangens-hyperbolicus-ähnliche Form haben.

6. Schaltung nach Anspruch 5, **dadurch gekennzeichnet, dass** die Regelcharakteristik für den regelbaren Verstärker im Wesentlichen dB-linear oder linear ist.

7. Schaltung nach einem oder mehreren der Ansprüche 4 bis 6, **dadurch gekennzeichnet, dass** der flache Teil der Kennlinie für die in der Mitte der Serienschaltung liegenden, in ihrem Widerstand steuerbaren Bauelemente (D3a, D3b) am niedrigsten ist und jeweils für die näher zu den Enden der Serienschaltung hin liegenden, in ihrem Widerstand steuerbaren Bauelemente (D1a, D1b) höher liegt.

8. Schaltung nach einem oder mehreren der Ansprüche 4 bis 7, **dadurch gekennzeichnet, dass** mehrere erfindungsgemäße Regelverstärker hintereinander geschaltet sind, wobei die Referenzspannungen ($V_{ref}$) für nachfolgende Regelverstärker jeweils höher sind als bei dem vorhergehenden.

9. Schaltung nach Anspruch 8, **dadurch gekennzeichnet, dass** jeweils ein entsprechendes, in seinem Widerstand steuerbares Bauelement (D1a-D3a, D1b-D3b) aus mindestens zwei aufeinanderfolgenden Regelverstärkern an eine gemeinsame Stromquelle (I1, I2, I3) angeschlossen ist.

10. Schaltung nach Anspruch 8 oder 9, **dadurch gekennzeichnet, dass** die hintereinander geschalteten Regelverstärker den wesentlichen Anteil eines integrierten ZF-Verstärker-Schaltkreises bilden.

11. Schaltung nach einem oder mehreren der Ansprüche 1 bis 10, **dadurch gekennzeichnet, dass** zusätzlich zu der Serienschaltung aus mindestens drei Widerständen ($R_{81a}$, $R_{801}$, $R_{81b}$) weitere Serienschaltungen von Widerständen ($R_{82a}$, $R_{802}$, $R_{82b}$, $R_{83a}$, $R_{803}$, $R_{83b}$) vorgesehen sind, das mindestens eine der weiteren Serienschaltungen aus mindestens drei Widerständen statt an den ersten und zweiten Transistor, an Widerständen einer der anderen Serienschaltungen angeschlossen ist, wobei zwischen den Widerständen dieser weiteren Serienschaltungen jeweils ein in seinem Widerstand steuerbares Bauelement (D82a, D83a, D82b, D83b) abzweigt, welches jeweils mit einer Stromquelle (I2, I3) verbunden ist und wobei der Strom dieser Stromquellen in Abhängigkeit von der Eingangsspannung ($V_{in}$) veränderbar ist.

## Claims

1. Circuit for a controllable amplifier, provided with a differential amplifier for an input voltage (Vin), which contains a first transistor (Q21,) and a second transistor (Q22), the emitters of which are connected to respective current sources, wherein the emitters are connected by resistors, **characterised in that**, the emitters are connected by a series circuit of at least three resistors (R1a-R4a, R1b-R4b; R81a, R801, R81b) wherein a respective component (D1a-D3a, D1b-D3b; D81a-D81b) whose resistance can be controlled is branched off between these resistors, each of said components being connected to a respective current source (I1, I2, I3), and wherein the current from these current sources can be altered in dependence on the input voltage (Vin), and wherein, in the event that the middle resistor (R801) of the resistors in the series circuit is divided into two individual resistors (R4a, R4b), no component having a controllable resistance is branched off from the junction of these two resistors.

2. Circuit according to Claim 1, **characterised in that** the current from the current sources (I1, I2, I3) is additionally dependent upon a reference voltage (Vref), whereby the respective reference voltage is lowest for the components (D3a, D3b) whose resistance can be controlled located in the centre of the series circuit and is highest for the components (D1a, D1b) whose resistance can be controlled located nearest to the ends of the series circuit.

3. Circuit according to claim 1 or 2, **characterised in that** the components (D1a-D3a, D1b-D3b) whose resistance can be controlled are diodes and/or FET Transistors formed as current controlled resistors, whereby, in particular, N-MOS-and P-MOS transistors are combined.

4. Circuit according to one or more of the claims 1 to 3, **characterised in that**, the characteristic curves (Fig. 3) of the currents from the current sources (I1, I2, I3) in the form "current amplitude depending on the gain of the control amplifier" each consist of a rising and of a flat section, wherein the rising section of the following characteristic curve always begins at the latest at the end of the rising section of a characteristic curve, and wherein the respective reference voltage (Vref) determines the beginning and/or end of the rising section of the characteristic curve.

5. Circuit according to one or more of the claims 1 to 4, **characterised in that** the characteristic curves (Fig. 4) of the currents from the current sources (I1, I2, I3) have a respective shape which, in essence, is similar to a hyperbolic tangent.

6. Circuit according to claim 5, **characterised in that**, the regulating characteristic for the controllable amplifier is essentially db-linear or linear.

7. Circuit according to one or more of the claims 4 to 6, **characterised in that**, the flat section of the characteristic curve is lowest for the components (D3a, D3b) whose resistance can be controlled located in the centre of the series circuit and is higher for the components (D1a, D1b) whose resistance can be controlled located nearer to the respective ends of the series circuit.

8.  Circuit according to one or more of the claims 4 to 7, **characterised in that** a plurality of controllable amplifiers in accordance with the invention are connected in series, whereby the reference voltages (Vref) for subsequent controllable amplifiers are always higher than for the preceding one.

9.  Circuit according to claim 8, **characterised in that**, on each occasion, a corresponding component (D1a-D3a, D1b-D3b) whose resistance can be controlled and consisting of at least two successive controllable amplifiers is connected to a common current source (I1, I2, I3).

10.  Circuit according to claim 8 or 9, **characterised in that** the series connected controllable amplifiers form the main part of an integrated IF amplifier circuit.

11.  Circuit according to one or more of the claims 1 to 10, **characterised in that**, in addition to the series circuit consisting of at least three resistors (R81a, R801, R81b), there are provided further series circuits of resistors (R82a, R802, R82b, R83a, R803, R83b), and that at least one of said further series circuits including at least three resistors is connected to the resistors of one of the other series circuits instead of to the first and second transistors, whereby a respective component (D82a, D83a, D82b, D83b) whose resistance can be controlled is branched off between the resistors of these further series circuits, which components are respectively connected to a current source (I2, I3), and wherein the current from these current sources can be altered in dependence on the input voltage ($V_{in}$).

**Revendications**

1.  Circuit pour un amplificateur réglable pourvu d'un amplificateur différentiel pour une tension en entrée ($V_{in}$), lequel comporte un premier transistor ($Q_{21}$) et un deuxième transistor ($Q_{22}$) dont les émetteurs sont chacun reliés à une source de courant, les émetteurs étant reliés entre eux par des résistances, **caractérisé en ce que** les émetteurs sont reliés par un circuit série composé d'au moins trois résistances (R1a-R4a, R1b-R4b, $R_{81a}$, $R_{801}$, $R_{81b}$), respectivement un composant (D1a-D3a, D1b-D3b, D81a-D81b) commandable en sa résistance partant d'entre ces résistances, lequel composant est respectivement relié à une source de courant (I1, I2, I3) et le courant de ces sources de courant pouvant être modifié en fonction de la tension en entrée ($V_{in}$) et, si la résistance du milieu ($R_{801}$) du circuit série est séparée en deux résistances individuelles (R4a, R4b), aucun composant commandable en sa résistance ne partant du point de liaison entre ces deux résistances.

2.  Circuit selon la revendication 1, **caractérisé en ce que** le courant de la source de courant (I1, I2, I3) dépend additionnellement d'une tension de référence ($V_{ref}$), la tension de référence respective étant la plus faible pour les composants (D3a, D3b) commandables en leur résistance qui sont situés au milieu du circuit série et étant la plus élevée pour les composants (D1a, D1b) commandables en leur résistance qui sont les plus proches des extrémités du circuit série.

3.  Circuit selon la revendication 1 ou 2, **caractérisé en ce que** les composants (D1a-D3a, D1b-D3b) commandables en leur résistance sont des diodes et/ou des transistors FET qui se présentent sous la forme de résistances commandables par courant, des transistors N-MOS et P-MOS, en particulier, étant combinés.

4.  Circuit selon l'une ou plusieurs des revendications 1 à 3, **caractérisé en ce que** les courbes caractéristiques (figure 3) des courants des sources de courant (I1, I2, I3) de forme «amplitude de courant en fonction de l'amplification de l'amplificateur de réglage» se composent d'une partie montante et d'une partie plate, la partie montante de la courbe caractéristique suivante commençant respectivement au plus tard à la fin de la partie montante d'une courbe caractéristique et la tension de référence respective ($V_{ref}$) déterminant le début et/ou la fin de la partie montante de la courbe caractéristique.

5.  Circuit selon l'une ou plusieurs des revendications 1 à 4, **caractérisé en ce que** les courbes caractéristiques (figure 4) des courants des sources de courant (I1, I2, I3) ont sensiblement respectivement une forme ressemblant à une tangente hyperbolique.

6.  Circuit selon la revendication 5, **caractérisé en ce que** la caractéristique de réglage de l'amplificateur réglable est sensiblement linéaire en dB ou linéaire.

7.  Circuit selon l'une ou plusieurs des revendications 4 à 6, **caractérisé en ce que** la partie plate de la courbe caractéristique est la plus basse pour les composants (D3a, D3b) commandables en leur résistance qui sont situés au milieu du circuit série et est respectivement plus élevée pour les composants (D1a, D1b) commandables en leur résistance qui sont plus proches des extrémités du circuit série.

8.  Circuit selon l'une ou plusieurs des revendications 4 à 7, **caractérisé en ce que** plusieurs amplificateurs de réglage selon l'invention sont montés en série, les tensions de référence ($V_{ref}$) pour des amplificateurs de réglage suivants étant respectivement plus élevées que pour le précédent.

9.  Circuit selon la revendication 8, **caractérisé en ce que** respectivement un composant correspondant (D1a-D3a, D1b-D3b) commandable en sa résistance et composé d'au moins deux amplificateurs de réglage successifs est connecté à une source de courant commune (I1, I2, I3).

10. Circuit selon la revendication 8 ou 9, **caractérisé en ce que** les amplificateurs de réglage montés en série constituent l'essentiel d'un circuit intégré d'amplificateurs de fréquence intermédiaire.

11. Circuit selon l'une ou plusieurs des revendications 1 à 10, **caractérisé en ce que**, en plus du circuit série composé d'au moins trois résistances ($R_{81a}$, $R_{801}$, $R_{81b}$), d'autres circuits série composés de résistances ($R_{82a}$, $R_{802}$, $R_{82b}$, $R_{83a}$, $R_{803}$, $R_{83b}$) sont prévus, **en ce qu'**au moins l'un des autres circuits série composés d'au moins trois résistances est connecté non pas aux premier et deuxième transistors, mais à des résistances de l'un des autres circuits série, respectivement un composant ($D_{82a}$, $D_{83a}$, $D_{82b}$, $D_{83b}$) commandable en sa résistance, lequel est respectivement relié à une source de courant (I2, I3), partant d'entre les résistances de ces autres circuits série et le courant de ces sources de courant pouvant être modifié en fonction de la tension en entrée ($V_{in}$).

FIG.1

FIG.2

FIG.3

FIG.4

FIG.5

FIG. 6

FIG.7

FIG.8

**EP 0 581 835 B3**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3522416 A